# EUROPÄISCHE PATENTANMELDUNG

(11) **EP 1 182 698 A2**
(43) Veröffentlichungstag der Anmeldung: **27.02.2002**
(21) Anmeldenummer: 01118994.1
(22) Anmeldetag: 06.08.2001
(51) Int. Cl.: H01L 21/285, H01L 21/02

(54) **Barriereschicht für einen Speicherkondensator**

(30) Priorität: 24.08.2000 DE 10041685
(71) Anmelder: Infineon Technologies AG, 81669 München (DE)
(72) Erfinder: Gabric, Zvonimir, 85604 Zorneding (DE); Hartner, Walter, Glen Allen, VA 23060 (US); Schindler, Günther, 80802 München (DE)
(74) Vertreter: Graf Lambsdorff, Matthias, Dr.

(57) **Zusammenfassung**

Die Erfindung betrifft ein Verfahren zur Herstellung eines mikroelektronischen Bauelements und ein derartiges Bauelement, bei welchen auf einen Speicherkondensator, der ein ferroelektrisches oder paraelektrisches Dielektrikum hat, eine Barriere gegen ein Hindurchtreten von Wasserstoff aufgebracht wird bzw. ist. Bei der Bildung der Barriere wird zunächst eine Siliziumoxid-Schicht (41) erzeugt, diese dann getempert und danach eine Barriereschicht (42) aufgebracht.

## Beschreibung

Die Erfindung betrifft ein Verfahren zur Herstellung eines mikroelektronischen Bauelements, bei welchem an einem Substrat ein Speicherkondensator gebildet wird und an dem Speicherkondensator eine gegen ein Hindurchtreten von Wasserstoff schützende Barriere gebildet wird. Die Erfindung betrifft weiterhin ein derartiges mikroelektronisches Bauelement.

Konventionelle mikroelektronische Halbleiterspeicher-Bauelemente (DRAMs) bestehen im wesentlichen aus einem Auswahloder Schalttransistor und einem Speicherkondensator, in welchem zwischen zwei Kondensatorplatten ein dielektrisches Material eingefügt ist. Als Dielektrikum werden üblicherweise zumeist Oxid- oder Nitridschichten verwendet, die eine Dielektrizitätszahl von maximal etwa 8 aufweisen. Zur Verkleinerung des Speicherkondensators sowie zur Herstellung von nicht-flüchtigen Speichern werden "neuartige" Kondensatormaterialien (Ferroelektrika oder Paraelektrika) mit deutlich höheren Dielektrizitätszahlen benötigt. Beispiele für solche Materialien sind in der Publikation "Neue Dielektrika für Gbit-Speicherchips" von W. Hönlein, Phys. Bl. 55 (1999), genannt. Zur Herstellung von ferroelektrischen Kondensatoren zum Einsatz in nicht-flüchtigen Halbleiterspeicher-Bauelementen hoher Integrationsdichte können z.B. ferroelektrische Materialien, wie SrBi₂(Ta,Nb)₂O₉ (SBT oder SBTN), Pb(Zr, Ti)O₃ (PZT), oder Bi₄Ti₃O₁₂ (BTO) als Dielektrikum zwischen den Kondensatorplatten eingesetzt werden. Es kann aber auch ein paraelektrisches Material, wie beispielsweise (Ba,Sr)TiO₃ (BST), zum Einsatz kommen.

Die Verwendung dieser neuartigen Dielektrika, stellt jedoch die Halbleiterprozeßtechnologie vor neue Herausforderungen. Zunächst lassen sich diese neuartigen Materialien nämlich nicht mehr mit dem traditionellen Elektrodenmaterial polykristallines Silizium kombinieren. Deshalb müssen inerte Elektrodenmaterialien, wie beispielsweise Platinmetalle oder deren leitfähige Oxide (z.B. RuO₂), eingesetzt werden. Der Grund hierfür liegt darin, daß nach dem Abscheiden des Ferroelektrikums dieses in einer sauerstoffhaltigen Atmosphäre bei Temperaturen von etwa 550-800°C gegebenenfalls mehrfach getempert ("konditioniert") werden muß. Zur Vermeidung von unerwünschten chemischen Reaktionen des Ferroelektrikums mit den Elektroden werden diese daher zumeist aus Platin oder einem anderen ausreichend temperaturstabilen und inerten Material, wie einem anderen Platinmetall (Pd, Ir, Rh, Ru, Os), gefertigt.

Zur Integration der Speicherkondensatoren werden Prozeßschritte ausgeführt, die in wasserstoffhaltiger Umgebung stattfinden. So ist beispielsweise zur Konditionierung der Metallisierung und der Transistoren eine Temperung in Formiergas notwendig, welches zu 95 % aus Stickstoff (N₂) und zu 5 % aus Wasserstoff (H₂) zusammengesetzt ist. Das Eindringen von Wasserstoff in den prozessierten Speicherkondensator, d.h. in das Dielektrikum, kann jedoch durch Reduktionsreaktionen zu einer Degradation der oxidischen Keramiken des Dielektrikums führen. Des weiteren können die plasmaunterstützte Abscheidung (PECVD) von Intermetalloxiden bzw. der Siliziumnitrid-Passivierungsschicht aufgrund des hohen Wasserstoffgehalts in den Schichten eine Reduktion des ferrobzw. paraelektrischen Materials des Dielektrikums bewirken. Auch bei der Abscheidung von elektrisch leitfähigen Materialien, etwa Refraktärmetallen wie Wolfram oder Titan, tritt Wasserstoff auf. Die Abscheidung dient beispielsweise der Erzeugung von Schichten oder dem Auffüllen von Kontaktlöchern.

Ferner beeinflußt das Eindringen von Wasserstoff in den Speicherkondensator auch die strukturellen Eigenschaften negativ. So kann es beispielsweise zu einem Peeling-Effekt kommen.

Es ist bereits bekannt, auf den Speicherkondensator als Barriere gegen das Eindringen von Wasserstoff eine Siliziumnitrid-Schicht aufzubringen. Siliziumnitrid wird beispielsweise nach dem LPCVD (Low Pressure Chemical Vapor Deposition)-Prozeß bei etwa 750°C abgeschieden. Die Ausgangsstoffe bei der Siliziumnitrid-Bildung sind SiH₂Cl₂ und NH₃. Bei der Abscheidung kommt es jedoch zu einer Wasserstoff-Radikalbildung und damit zur Schädigung des Speicherkondensators.

Weiterhin ist es bekannt, Wasserstoffbarrieren aus Materialien zu bilden, die ohne die Anwesenheit von Wasserstoff abgeschieden werden können. Beispiele für solche Materialien sind AlOₓ, TiOₓ und TiOₓN_{y}. Diese oxidischen Materialien sind jedoch schwer zu ätzen, so daß nach dem Aufbringen der üblichen Siliziumoxid-Schicht auf die Barriere nur unter großem Aufwand Kontaktlöcher zu den Elektroden der Speicherkondensatoren und/oder durch die Barriere hindurch zu dem Substratmaterial geätzt werden können.

Es wurde auch bereits vorgeschlagen, das Auffüllen von Kontaktlöchern mit Wolfram, welches in Anwesenheit von Wasserstoff erfolgt, wegzulassen und statt dessen Aluminium zu verwenden. Heutige kommerziell erhältliche Produkte mit ferroelektrischen Dielektrika werden daher mit Aluminium als Metallisierungsmaterial ausgeführt. Mit Wolfram läßt sich jedoch ein aufzufüllender Bereich wesentlich zuverlässiger auffüllen als mit Aluminium. Im Zuge weiterer Miniaturisierung und weiterer Erhöhung der Speicherdichten von Halbleiterspeichern muß jedenfalls auf heutige bekannte Verfahren zum Auffüllen mit Aluminium verzichtet werden.

Aufgabe der vorliegenden Erfindung ist es, ein Verfahren und ein mikroelektronisches Bauelement der eingangs genannten Art anzugeben, die es erlauben, nach dem Aufbringen einer wirksamen Wasserstoffbarriere auf einfache Weise Kontaktlöcher zu ätzen. Dabei soll durch das Aufbringen der Wasserstoffbarriere keine erhebliche Schädigung des Speicherkondensators bewirkt werden.

Die Aufgabe wird durch ein Verfahren mit den Merkmalen des Anspruchs 1 und durch ein Bauelement mit den Merkmalen des Anspruchs 12 gelöst. Weiterbildungen sind Gegenstand der jeweils anhängigen Ansprüche.

Ein wesentlicher Gedanke bei dem erfindungsgemäßen Verfahren besteht darin, bei der Barrierebildung zunächst eine Siliziumoxid-Schicht zu erzeugen. Der Speicherkondensator und zumindest ein Teil der Siliziumoxid-Schicht werden getempert, d.h. insbesondere unmittelbar auf die Abscheidung der Siliziumoxid-Schicht folgend einer Temperaturbehandlung unterzogen. Beispielsweise werden der Speicherkondensator und die Siliziumoxid-Schicht bei einer Temperatur von 500°C oder höher, vorzugsweise 650°C oder höher, in einer Sauerstoffatmosphäre ausgeheizt.

Auf die getemperte Siliziumoxid-Schicht wird eine Barriereschicht aufgebracht, die gegen ein Hindurchtreten von Wasserstoff schützt.

Insbesondere wenn die Elektroden des Speicherkondensators Platin oder ein Platinmetall enthalten, nimmt die Siliziumoxid-Schicht dem Platin oder Platinmetall die katalytische Aktivität, die bei Anwesenheit von Wasserstoff zu einer besonders schweren Schädigung des Speicherkondensators führen kann. Nachfolgende Prozeßschritte, bei denen Wasserstoff anwesend ist, führen daher nur zu einer geringen oder gar keinen Schädigung des Speicherkondensators. Vorzugsweise wird die Siliziumoxid-Schicht daher unmittelbar auf das Elektrodenmaterial aufgebracht.

Die Temperung bzw. das Ausheizen des Speicherkondensators und mindestens eines Teils der Siliziumoxid-Schicht bewirkt, daß Wasserstoff, der beim Aufbringen der Siliziumoxid-Schicht in die Nähe des Speicherkondensators vorgedrungen ist oder in diesen eingedrungen ist, wieder entfernt wird. Vorteilhafterweise findet die Temperung in sauerstoffhaltiger Atmosphäre statt, so daß der Sauerstoff den Wasserstoff bindet (Wassermolekül-Bildung). Die Temperung führt bereits vor dem Aufbringen der Wasserstoffbarriere-Schicht zu der erforderlichen Konditionierung des Dielektrikums.

Vorzugsweise wird zumindest ein Teil der Siliziumoxid-Schicht in einem Niedertemperatur-Prozeß, insbesondere einem PECVD (Plasma Enhanced Chemical Vapor Deposition)-Prozeß abgeschieden. Die Temperatur dabei beträgt beispielsweise etwa 350°C. Ein wesentlicher Vorteil des Niedertemperatur-Prozesses besteht darin, daß der anwesende Wasserstoff nicht zu einer dauerhaften Schädigung des Speicherkondensators führt. Durch die nachfolgende Temperung, vorzugsweise bei deutlich höheren Temperaturen, ist ein Eindringen von Wasserstoff in den Speicherkondensator reversibel. Außerdem laufen bei der niedrigen Temperatur nicht die chemischen Reaktionen des Wasserstoffs mit dem Dielektrikumsmaterial statt, die bei hohen Temperaturen ablaufen können.

Durch die Temperung wird die Siliumoxid-Schicht in der Regel verdichtet, insbesondere wenn die Temperung bei höherer Temperatur als das Abscheiden erfolgt. Bereits dadurch entsteht ansatzweise ein Schutz gegen das Hindurchtreten von Wasserstoff.

Schließlich wirkt sich die Temperung der Siliziumoxid-Schicht günstig auf ihr Verhalten während der weiteren Verfahrensschritte aus, da die Siliziumoxid-Schicht bereits während der Temperung den Temperaturen ausgesetzt ist, die in der Regel zu einer Strukturänderung führen. Derartige Strukturänderungen sind beispielsweise während des nachfolgenden Aufbringens der Barriereschicht unerwünscht, weil sie sich ungünstig auf die Struktur und das Haftungsverhalten der Barriereschicht auswirken können. Entsprechendes gilt für nachfolgend auf die Barriereschicht aufgebrachte Materialien, etwa einer Isolationsschicht, die den Speicherkondensator und die Barriere einbettet.

Vorzugsweise wird eine Teilschicht der Siliziumoxid-Schicht, die auf eine bereits aufgebrachte Teilschicht aufgebracht wird, in einem Hochtemperatur-Prozeß, insbesondere einem HTO (High Temperature Oxide)-Prozeß, abgeschieden. Aufgrund der hohen Temperatur kann ohne nachfolgende Temperung dieser Teilschicht Siliziumoxid mit hoher Dichte erzeugt werden. Dennoch wird bevorzugt, auch nach dem Aufbringen dieser Teilschicht eine Temperung durchzuführen, um etwaige Schäden durch eingedrungenen Wasserstoff des Speicherkondensators auszuheilen und/oder eingedrungenen Wasserstoff auszuheizen.

Durch die Erfindung ist es möglich, für die elektrische Kontaktierung, insbesondere für das Auffüllen von Kontaktlöchern, die in die genannte Isolationsschicht und die Barriere eingebracht werden, Wolfram zu verwenden, da der Kondensator durch die Barriere wirksam gegen ein Eindringen von Wasserstoff schützbar ist. Somit ist eine weitere Miniaturisierung möglich und können höhere Speicherdichten bei mikroelektronischen Speicherbausteinen erzielt werden.

Vorzugsweise wird zumindest ein Teil der Barriereschicht in einem wasserstoffreien Abscheideprozeß auf die getemperte Siliziumoxid-Schicht aufgebracht. Dabei kann die Dicke dieses Teils der Barriereschicht so gering gehalten werden, daß bei an sich schwer ätzbaren Materialien wie Metalloxiden die Barriereschicht mit vertretbarem Aufwand geätzt werden kann. Wird eine derartige Teilschicht der Barriereschicht aufgebracht, dann kann eine weitere Teilschicht unter Anwesenheit von Wasserstoff aufgebracht werden, da der zuvor aufgebrachte Teil der Barriereschicht den Speicherkondensator schon vor dem Wasserstoff schützt.

Werden zumindest Teile der Barriereschicht unter Anwesenheit von Wasserstoff aufgebracht bzw. abgeschieden, so wird vorzugsweise danach eine Temperung des Speicherkondensators, der Siliziumoxid-Schicht und des bereits aufgebrachten Teils der Barriereschicht durchgeführt. Hierfür gilt Entsprechendes wie für die Temperung vor dem Aufbringen der Barriereschicht.

Bei einer bevorzugten Ausführungsform besteht eine Teilschicht der Barriereschicht, die jedoch nicht die zuerst aufgebrachte Teilschicht ist, aus Siliziumnitrid bzw. wird eine Siliziumnitrid-Schicht aufgebracht. In diesem Fall wirkt die zuvor aufgebrachte zumindest eine Teilschicht der Barriereschicht als Puffer für den beim Aufbringen der Siliziumnitrid-Schicht anwesenden Wasserstoff. Je nach Material der zuvor aufgebrachten Teilschicht ist diese eine Barriere und/oder ein Speicher für Wasserstoff. Materialien, die Wasserstoff speichern, sind beispielsweise Titan und die meisten seiner Verbindungen.

Als Materialien für die Barriereschicht eignen sich insbesondere Ti, TiN, TiOₓ (beispielsweise reaktiv gesputtert oder oxidiert aus Ti bei z.B. 700°C, 5 Minuten lang in Sauerstoffatmosphäre), Ta, TaN, TaOₓ (z.B. reaktiv gesputtert oder oxidiert aus Ta bei z.B. 700°C, 5 Minuten lang in Sauerstoffatmosphäre), AlOₓ, NbOₓ, ZrOₓ und/oder SiₓN_{y}.

Insbesondere eine Barriereschicht oder Teilschicht aus SiₓN_{y} kann in einem LPCVD (Low Pressure Chemical Vapor Deposition)-Prozeß bei etwa 600-750°C, bevorzugt 660°C und einem Druck von 30 Pa abgeschieden werden. Weiterhin kann eine SiₓN_{y}-Schicht in einem LP (Low Pressure)-Mikrowellenprozeß abgeschieden werden, in dem zumindest ein Prekursor des SiₓN_{y} durch Mikrowellenstrahlung aktiviert wird. Auf diese Weise läßt sich das bei dem LPCVD-Prozeß anwesende NH₃ vermeiden, das ein Ausgangsstoff für die Bildung von Wasserstoff ist.

Die SiN-Schicht kann auch durch Sputtern hergestellt werden, wodurch ebenfalls das Auftreten von H₂ während der Abscheidung vermieden wird.

Durch die Bildung der Siliziumoxid-Schicht in Form von zwei oder mehr als zwei Teilschichten, wobei die Teilschichten in unterschiedlichen Herstellungsprozessen aufgebracht werden und daher unterschiedliche Oxidstruktur aufweisen, können wie oben beschrieben Schäden an dem Speicherkondensator weitgehend vermieden werden. Weiterhin können dadurch eine gute Grundlage für das Aufbringen der eigentlichen Barriereschicht gebildet werden und die katalytische Wirkung von in einer außen liegenden Elektrode des Speicherkondensators vorhandenem Platin oder Platinmetall vermindert werden.

Die Barriereschicht weist vorzugsweise zwei Teilschichten aus unterschiedlichem Material auf. Insbesondere ist die näher an der Siliziumoxid-Schicht gelegene Teilschicht aus einem metalloxidhaltigen Material und hat eine Schichtdicke von 50 nm oder weniger, vorzugsweise ca. 20 nm. Als Metalle für die Metalloxide kommen außer den bereits genannten Metallen alle Übergangsmetalle in Frage. Alternativ kommen als Material für eine Teilschicht der Barriereschicht oder für die Barriereschicht insgesamt Nitride der Übergangsmetalle in Frage. Insbesondere ist die weiter von der Siliziumoxid-Schicht entfernt gelegene Teilschicht eine Siliziumnitrid-Schicht mit vorzugsweise einer Schichtdicke von ca. 25 nm.

Die Erfindung wird nun anhand von Ausführungsbeispielen näher erläutert. Dabei wird Bezug auf die beigefügte Zeichnung genommen. Die einzelnen Figuren der Zeichnung zeigen:
- Fig. 1: einen Querschnitt durch eine DRAM-Speicherzelle gemäß dem Stacked Cell-Aufbau und eine DRAM-Speicherzelle nach dem Offset Cell-Aufbau.
- Fig. 2: einen Querschnitt durch zwei weitere derartige Speicherzellen,
- Fig. 3: einen Querschnitt durch den Schichtaufbau einer Wasserstoffbarriere gemäß einer ersten Ausführungsform und
- Fig. 4: einen Querschnitt durch eine Wasserstoffbarriere gemäß einer zweiten Ausführungsform.

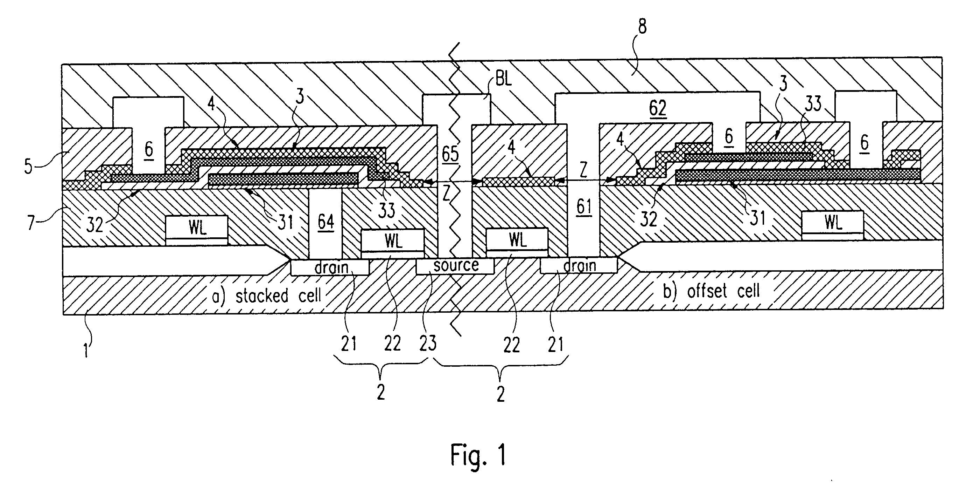

In Fig. 1 sind im linken Figurenteil eine Stacked Cell-Speicherzelle und im rechten Figurenteil eine Offset Cell-Speicherzelle auf einem gemeinsamen Halbleitersubstrat 1 dargestellt. Die gezackte Linie etwa in der Figurenmitte deutet an, daß die beiden unterschiedlichen Speicherzellen in der Praxis üblicherweise nicht auf demselben Halbleitersubstrat angeordnet sind.

Auf dem Halbleitersubstrat 1 ist ein für beide Speicherzellen gemeinsamer Source-Bereich 23 vorgesehen. Weiterhin ist jeweils ein Drain-Bereich 21 vorgesehen. Zwischen Drain und Source befindet sich jeweils ein Gate 22, so daß für jede der beiden Speicherzellen ein MOS-Transistor 2 gebildet ist, der als Auswahltransistor dient. Das Gate 22 ist jeweils elektrisch an eine Wortleitung WL angeschlossen. Die Wortleitungen WL und die MOS-Transistoren 2 sind in eine erste Isolationsschicht 7 eingebettet, die beispielsweise aus SiO₂ besteht.

Der Drain-Bereich 21 der im linken Figurenteil dargestellten Stacked Cell-Speicherzelle ist über ein mit Wolfram aufgefülltes Kontaktloch 64 mit einer über der ersten Isolationsschicht 7 angeordneten ersten Elektrode 31 eines Speicherkondensators 3 verbunden. Auf die erste Elektrode 31 ist ein Dielektrikum 32 aus einem ferroelektrischen Material oder aus einem paraelektrischen Material mit einer Dielektrizitätszahl von mehr als 8 aufgebracht. Wiederum auf das Dielektrikum 32 ist eine zweite Elektrode 33 aufgebracht, so daß die erste und die zweite Elektrode 31, 33 mit dem dazwischen liegenden Dielektrikum 32 den Speicherkondensator 3 bilden.

Bezüglich des grundsätzlichen Aufbaus des Speicherkondensators 3 gilt das Gleiche im Fall der im rechten Figurenteil dargestellten Offset Cell-Speicherzelle. Die Offset Cell und die Stacked Cell unterscheiden sich jedoch hinsichtlich der Erstreckung der Kondensatorschichten 31, 32, 33 entlang der Oberfläche der ersten Isolationsschicht 7 und hinsichtlich der elektrischen Kontaktierung der Elektroden 31, 33. Bei der Stacked Cell ist die Elektrode 31, wie bereits beschrieben, von unten kontaktiert. Bei der Offset Cell dagegen ist die erste Elektrode 31 in einem Bereich, in dem sich weder das Dielektrikum 32 noch die zweite Elektrode 33 über der ersten Elektrode 31 erstrecken, von oben kontaktiert. Hierzu ist ein Kontaktloch 6 durch eine den Speicherkondensator 3 einbettende zweite Isolationsschicht 5 hindurch geätzt worden und mit Wolfram aufgefüllt worden. Die Kontaktierung der zweiten Elektrode 33 erfolgt bei beiden Zellentypen von oben, jeweils durch ein Kontaktloch 6 in der zweiten Isolationsschicht 5 hindurch. Bei der Offset Cell (rechter Figurenteil) ist die zweite Elektrode 33 weiterhin über eine elektrische Verbindung 62, die sich entlang der Oberfläche der zweiten Isolationsschicht 5 erstreckt, und über ein mit Wolfram aufgefülltes Kontaktloch 61 durch die erste und die zweite Isolationsschicht 5, 7 hindurch mit dem Drain-Bereich 21 elektrisch verbunden. Ein weiteres Kontaktloch 65 erstreckt sich ausgehend von dem Source-Bereich 23 durch die erste und die zweite Isolationsschicht 5, 7 hindurch bis an die Oberfläche der zweiten Isolationsschicht 5 zu einer Bitleitung BL.

Die Offset Cell nimmt somit inklusive ihrer elektrischen Kontaktierung und inklusive des MOS-Transistors 2 ein wesentlich größeres Bauvolumen in Anspruch. Die Stacked Cell stellt dagegen höhere Anforderungen hinsichtlich Präzision und Aufwand bei ihrer Fertigung.
Bei beiden Speicherzellentypen ist auf die zweite Elektrode 33 eine schichtartige Barriere 4 aufgebracht, die den Speicherkondensator 3 gegen ein Eindringen von Wasserstoff schützen soll. Insbesondere bestehen die Dielektrika 32 der Speicherkondensatoren 3 aus einem der bereits genannten wasserstoffempfindlichen Materialien.

Bei den in Fig. 1 dargestellten Speicherzellen wurde zunächst die Dielektrikumsschicht strukturiert und anschließend die Barriere 4 aufgebracht. Um das spätere Ätzen der Kontaktlöcher 61, 65 zu erleichtern, wurde die Barriere 4 so strukturiert, daß in den Bereichen der späteren Kontaktlöcher 61, 65 jeweils eine Öffnung mit einer Weite Z vorhanden ist, die größer als die Weite des Kontaktloches 61, 65 ist. Nach der Strukturierung der Barriere 4 wurde die zweite Isolationsschicht 5 aufgebracht. Anschließend wurden die Kontaktlöcher 6, 61, 65 geätzt und metallisiert. Schließlich wurde noch eine Deckschicht 8 auf die Oberfläche der zweiten Isolationsschicht 5 bzw. auf die Metallisierung aufgebracht.

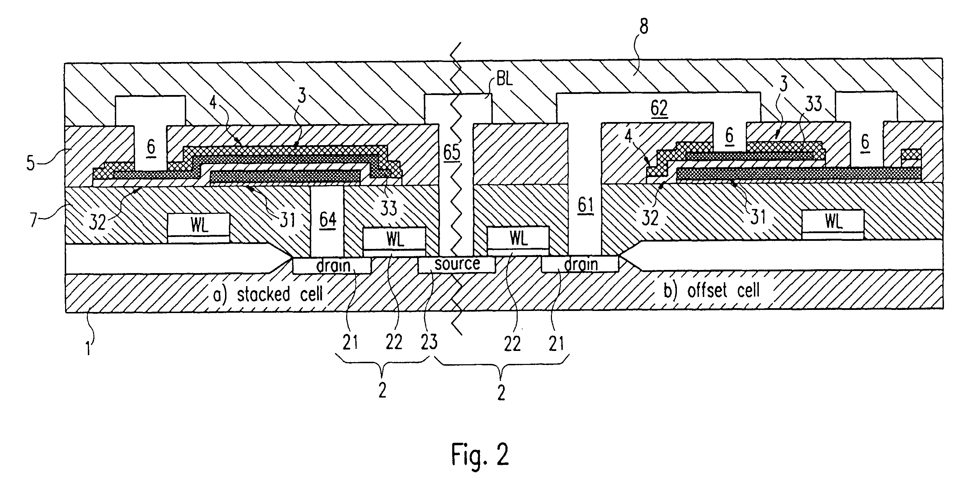

In Fig. 2 sind ebenfalls jeweils eine Speicherzelle des Stakked Cell-Typs und des Offset Cell-Typs dargestellt. Diese beiden Speicherzellen unterscheiden sich hinsichtlich der Strukturierung der Barriere 4 von den in Fig. 1 dargestellten Speicherzellen. Hier wurden die Barriere 4 und das Dielektrikum 32 gemeinsam strukturiert, insbesondere unter Verwendung derselben oder gleichartiger Masken. Dies bedeutet einerseits eine Vereinfachung des Herstellungsprozesses, führt andererseits jedoch dazu, daß die Ränder der Dielektrikumsschicht nicht durch die Barriere 4 abgedeckt sind. Von Vorteil ist es bei der Offset Cell nach Fig. 2, daß die Barriere 4 nicht in Kontakt mit der ersten Elektrode 31 ist. Daher können für die Barriere 4 uneingeschränkt auch elektrisch leitende Materialien verwendet werden. Sollen solche Materialien auch bei der Barriere 4 der Offset Cell nach Fig. 1 eingesetzt werden, sind besondere Maßnahmen erforderlich, beispielsweise konstruktive Veränderungen oder es muß eine zuerst aufgebrachte Teilschicht der Barriere 4 aus elektrisch isolierendem Material bestehen.

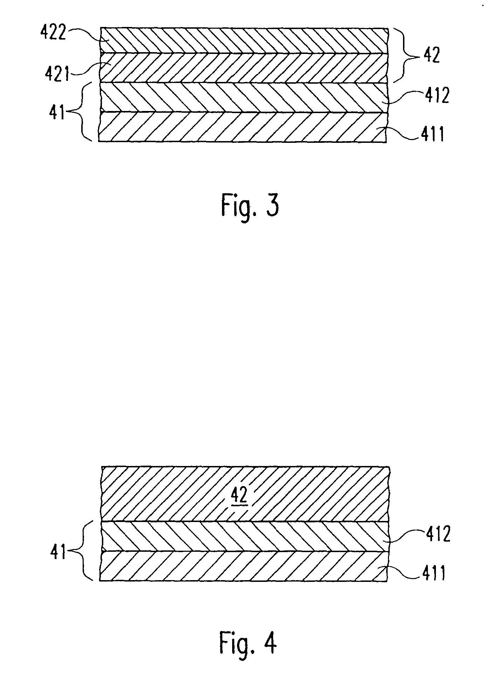

Ausführungsbeispiele einer Barriere gegen das Hindurchtreten von Wasserstoff, wie sie bei den in Fig. 1 und Fig. 2 dargestellten Speicherzellen vorhanden sind, werden nunmehr anhand von Fig. 3 und Fig. 4 näher erläutert.

Fig. 3 zeigt einen vierschichtigen Aufbau mit einer Siliziumdioxid-Schicht 41, bestehend aus einer unteren Teilschicht 411 und einer oberen Teilschicht 412, und mit einer Barriereschicht 42, bestehend aus einer unteren Teilschicht 421 und einer oberen Teilschicht 422. Die untere Teilschicht 411 der Siliziumdioxid-Schicht 41 wird beispielsweise unmittelbar auf die zweite Elektrode 33 der in Fig. 1 und Fig. 2 dargestellten Speicherkondensatoren 3 aufgebracht, und zwar als TEOS-Oxid in einem PECVD (Plasma Enhanced Chemical Vapor Deposition)-Prozeß, wobei ein Plasma gezündet wird und so die Reaktion zu SiO₂ angeregt wird.

Nach dem Aufbringen der ersten Teilschicht 411 wird der Speicherkondensator mitsamt der ersten Teilschicht 411 einer Temperung, vorzugsweise bei einer Temperatur von 700°C, 30 Minuten lang in Sauerstoffatmosphäre bei Atmosphärendruck unterzogen. Dies führt zum Ausheilen (annealing) des insbesondere keramischen Dielektrikums, zum Austreiben des bei der Herstellung der ersten Teilschicht 411 in den Speicherkondensator eingedrungenen Wasserstoffs und zur Verdichtung und damit zur Vorbereitung der unteren Teilschicht 411 für die weiteren Verfahrensschritte. Alternativ kann die Temperung auch in kürzerer Zeit und bei anderen Temperaturen erfolgen. Gute Ergebnisse lassen sich vor allem dann erzielen, wenn die Temperatur des Speicherkondensators und der unteren Teilschicht 411 während der Temperung mindestens 5 Minuten lang 500°C beträgt.

Nach der Temperung wird in einem HTO (High Temperature Oxide)-Prozeß mit den Ausgangsgasen SiH₄ und N₂O bei ca. 700°C und einem Druck von 40 Pa die obere Teilschicht 412 unmittelbar auf der Oberfläche der ersten Teilschicht 411 abgeschieden. Anschließend werden die gesamte Siliziumdioxid-Schicht 41 und der Speicherkondensator wieder einer Temperung unterzogen, insbesondere unter denselben Bedingungen wie unmittelbar nach dem Aufbringen der unteren Teilschicht 411.

Durch das Aufbringen der Siliziumdioxid-Schicht 41 in mehreren Schritten werden einerseits eine Schädigung des Speicherkondensators verhindert bzw. durch Temperung Schäden ausgeheilt und andererseits eine Siliziumdioxid-Schicht mit hoher Qualität aufgebracht. Beim Aufbringen der unteren Teilschicht 411 ist die Temperatur verhältnismäßig gering, so daß nur eine geringe Schädigung des Speicherkondensators stattfindet.

Die insbesondere für die in Fig. 1 und Fig. 2 dargestellten Speicherzellen erforderliche Kantenbedeckung und Bedeckung der Ränder der darunter liegenden Kondensatorschichten 32, 33 ist durch das Aufbringen der unteren Teilschicht 411 noch nicht befriedigend. Die untere Teilschicht 411 verhindert aber bereits bei dem Hochtemperatur-Prozeß, in dem die obere Teilschicht 412 aufgebracht wird, eine weitergehende Schädigung des Speicherkondensators, insbesondere aufgrund einer Abschirmung des anwesenden Wasserstoffs und indem die katalytische Wirkung des etwaig in den Elektroden 31, 33 vorhandenen Platins oder Platinmetalls vermindert wird. Die in dem Hochtemperatur-Prozeß abgeschiedene obere Teilschicht 412 weist eine sehr gute Kantenbedeckung und Randbedeckung darunter liegender Schichten auf.

Nach der zweiten Temperung wird unmittelbar auf die obere Teilschicht 412 der Siliziumdioxid-Schicht 41 die untere Teilschicht 421 der Barriereschicht 42 aufgebracht. Die hierfür erforderlichen Abscheideprozesse sind an sich bekannt und richten sich nach dem jeweiligen Material der unteren Teilschicht 421. Diese kann beispielsweise aus ZrOₓ, TiN, Ti oder AlOₓ bestehen. Nach dem Aufbringen der unteren Teilschicht 421 kann erneut getempert werden.

Unmittelbar auf die untere Teilschicht 421 wird die obere Teilschicht 422 der Barriereschicht 42 aufgebracht. Vorzugsweise ist das Material der oberen Teilschicht 422 Si₃N₄, welches in einem LPCVD (Low Pressure Chemical Vapor Deposition)-Prozeß bei ca. 750°C und einem Druck von 30 Pa oder in einem PECVD-Prozeß abgeschieden wird. Das in diesem Prozeß abgeschiedene Si₃N₄ weist eine hervorragende Barrierewirkung gegen das Hindurchtreten von Wasserstoff auf und enthält selbst praktisch keinen Wasserstoff. Da jedoch bei der Herstellung der Si₃N₄-Schicht die wasserstoffhaltigen Gase SiH₂Cl₂ (SiH₄) und NH₃ verwendet werden, wirkt sich das vorherige Aufbringen der unteren Teilschicht 421 vorteilhaft aus und bewahrt den Speicherkondensator vor irreversiblen Schäden. Die untere Teilschicht 421 kann in einem wasserstoffreien Abscheidprozeß hergestellt werden und insbesondere aus einem der in der Regel schwer ätzbaren Metalloxiden bestehen. Da die untere Teilschicht 421 der Barriereschicht 42 jedoch noch nicht die vollständige Barrierewirkung der gesamten Barriereschicht 42 haben muß, kann die untere Teilschicht 421 eine verhältnismäßig geringe Schichtdicke von beispielsweise etwa 20 nm aufweisen, so daß die Schicht mit vertretbarem Aufwand ätzbar ist. Die Schichtdicken der anderen Teilschichten betragen beispielsweise etwa: 25 nm bei der unteren Teilschicht 411 der Siliziumdioxid-Schicht 41, 25 nm bei der oberen Teilschicht 412 der Siliziumdioxid-Schicht 41 und 25 nm bei der oberen Teilschicht 422 der Barriereschicht 42.

Ein weiteres Ausführungsbeispiel einer Barriere gegen das Hindurchtreten von Wasserstoff ist in Fig. 4 dargestellt. Dabei werden die untere Teilschicht 411 und die obere Teilschicht 412 der Siliziumdioxid-Schicht 41 insbesondere in derselben Weise hergestellt und getempert wie die entsprechenden Schichten des Ausführungsbeispiels nach Fig. 3. Die Barriereschicht 42 nach Fig. 4 besteht jedoch aus einem Material und wird vorzugsweise in einem kontinuierlichen Prozeß aufgebracht. Um eine gute Barrierewirkung zu entfalten, wird eine Schichtdicke der Barriereschicht 42 von 50 bis 100 nm bevorzugt. Weiter wird bevorzugt, als Material ein leicht ätzbares Material zu wählen, insbesondere TiN, TaN oder ein anderes Nitrid von Übergangsmetallen. Denkbar als Material für die Barriereschicht 42 ist ebenfalls LPCVD-SiN, PECVD-SiN, HOₓ oder ZrOₓ.

Die Erfindung ist nicht auf die anhand der Figuren näher beschriebenen Ausführungsbeispiele beschränkt. Vielmehr kann beispielsweise die Siliziumoxid-Schicht eine einzige in einem kontinuierlichen Verfahrensschritt erzeugte Schicht sein und/oder kann die Temperung einer Mehrzahl von Teilschichten erst nach dem Aufbringen der Teilschichten erfolgen. In jedem Fall jedoch führt die Temperung zu einer Verbesserung der Eigenschaften eines Speicherkondensators.

## Patentansprüche

1. Verfahren zur Herstellung eines mikroelektronischen Bauelements, bei welchem
a) an einem Substrat (1) ein Speicherkondensator (3) gebildet wird, enthaltend
- eine erste Elektrode (31),
- eine zweite Elektrode (32) und
- zwischen den Elektroden (31, 32) ein ferroelektrisches oder paraelektrisches Dielektrikum (33),
und
a) an dem Speicherkondensator (3) eine gegen ein Hindurchtreten von Wasserstoff schützende Barriere (4) gebildet wird,
**dadurch gekennzeichnet, daß**
bei der Barrierebildung
- zunächst eine Siliziumoxid-Schicht (41) erzeugt wird,
- der Speicherkondensator (3) und zumindest ein Teil der Siliziumoxid-Schicht (41) getempert werden und
- auf die getemperte Siliziumoxid-Schicht (41) eine Barriereschicht (42) aufgebracht wird, die gegen ein Hindurchtreten von Wasserstoff schützt.

2. Verfahren nach Anspruch 1,
**dadurch gekennzeichnet, daß**
zumindest ein Teil der Barriereschicht (42) in einem wasserstoffreien Abscheideprozeß aufgebracht wird.

3. Verfahren nach Anspruch 1 oder 2,
**dadurch gekennzeichnet, daß**
die Barriereschicht (42) aus einer Mehrzahl von Teilschichten (421, 422) gebildet wird, die jeweils gegen ein Hindurchtreten von Wasserstoff schützen.

4. Verfahren nach Anspruch 3,
**dadurch gekennzeichnet, daß**
eine erste Teilschicht (421) der Barriereschicht (42) aufgebracht wird und danach eine zweite Teilschicht (422) aus Siliziumnitrid aufgebracht wird.

5. Verfahren nach Anspruch 4,
**dadurch gekennzeichnet, daß**
die Siliziumnitrid-Schicht in einem LP (Low Pressure)-Mikrowellenprozeß abgeschieden wird, in dem zumindest ein Prekursor des Siliziumnitrids durch Mikrowellenstrahlung aktiviert wird.

6. Verfahren nach einem der Ansprüche 1 bis 5,
**dadurch gekennzeichnet, daß**
zumindest ein Teil der Barriereschicht (42) nach seinem Aufbringen getempert wird.

7. Verfahren nach einem der Ansprüche 1 bis 6,
**dadurch gekennzeichnet, daß**
die Siliziumoxid-Schicht (41) aus einer Mehrzahl von Teilschichten (411, 412) gebildet wird.

8. Verfahren nach Anspruch 7,
**dadurch gekennzeichnet, daß**
die erste Teilschicht (411) in einem Niedertemperatur-Prozeß, insbesondere einem PECVD (Plasma Enhanced Chemical Vapor Deposition)-Prozeß abgeschieden wird.

9. Verfahren nach Anspruch 7 oder 8,
**dadurch gekennzeichnet, daß**
eine folgende Teilschicht (412) in einem Hochtemperatur-Prozeß, insbesondere einem HTO (High Temperature Oxide)-Prozeß abgeschieden wird.

10. Verfahren nach einem Ansprüche 7 bis 9,
**dadurch gekennzeichnet, daß**
die Temperung des Speicherkondensators (3) nach dem Aufbringen einer Teilschicht (411, 412), insbesondere jeweils nach dem Aufbringen einer der Teilschichten (411, 412), der Siliziumoxid-Schicht (41) durchgeführt wird.

11. Verfahren nach einem der Ansprüche 1 bis 10,
**dadurch gekennzeichnet, daß**
die Temperung des Speicherkondensators (3) und der Siliziumoxid-Schicht (41) in sauerstoffhaltiger Atmosphäre bei Temperaturen von mindestens 500°C, vorzugsweise mindestens 650°C durchgeführt wird.

12. Mikroelektronisches Bauelement mit:
a) einem Substrat (1),
b) einem auf dem Substrat (1) gebildeten Speicherkondensator (3), enthaltend:
- eine erste Elektrode (31),
- eine zweite Elektrode (32) und
- zwischen den Elektroden (31, 32) ein ferroelektrisches oder paraelektrisches Dielektrikum (33),
und
a) einer auf einer der Elektroden (31, 32) aufgebrachten Barriere (4), die den Speicherkondensator (3) gegen ein Hindurchtreten von Wasserstoff durch die Barriere (4) schützt,
**dadurch gekennzeichnet, daß**
die Barriere (4) aufweist:
- eine auf der Elektrode (31) aufgebrachte Siliziumoxid-Schicht (41), die in sauerstoffhaltiger Atmosphäre getempert wurde, und
- eine auf die Siliziumoxid-Schicht (41) aufgebrachte Barriereschicht (42), die den Speicherkondensator (3) gegen ein Hindurchtreten von Wasserstoff schützt.

13. Bauelement nach Anspruch 12,
**dadurch gekennzeichnet, daß**
der Speicherkondensator (3) und die Barriere (4) in eine auf die Barriere (4) aufgebrachte Isolationsschicht (5) eingebettet sind.

14. Bauelement nach Anspruch 13,
**dadurch gekennzeichnet, daß**
in die Isolationsschicht (5) ein mit Wolfram aufgefülltes Kontaktloch (6) eingebracht ist, so daß eine der Elektroden (31, 33) elektrisch kontaktiert ist.

15. Bauelement nach einem der Ansprüche 12 bis 14,
**dadurch gekennzeichnet, daß**
die Siliziumoxid-Schicht (41) zwei getemperte Teilschichten (411, 412) unterschiedlicher Oxidstruktur aufweist.

16. Bauelement nach einem der Ansprüche 12 bis 15,
**dadurch gekennzeichnet, daß**
die Barriereschicht (42) zwei Teilschichten (421, 422) aus unterschiedlichem Material aufweist.

17. Bauelement nach Anspruch 16,
**dadurch gekennzeichnet, daß**
die näher an der Siliziumoxid-Schicht (41) gelegene Teilschicht (421) aus einem metalloxidhaltigen Material besteht und eine Schichtdicke von 50 nm oder weniger, vorzugsweise ca. 20 nm, hat.

18. Bauelement nach Anspruch 16 oder 17,
**dadurch gekennzeichnet, daß**
die weiter von der Siliziumoxid-Schicht (41) gelegene Teilschicht (422) eine Siliziumnitrid-Schicht ist, vorzugsweise mit einer Schichtdicke von 20 bis 30 nm.
